# EUROPÄISCHE PATENTANMELDUNG

(11) **EP 1 674 591 A1**
(43) Veröffentlichungstag der Anmeldung: **28.06.2006**
(21) Anmeldenummer: 05020417.1
(22) Anmeldetag: 20.09.2005
(51) Int. Cl.: C23C 14/58, C23C 16/56, C23C 2/28, C23C 4/18, C23C 8/80, C23C 10/60, C23C 14/56, C23C 16/54

(54) **Vorrichtung und Verfahren zum Kühlen von Substraten**

(30) Priorität: 09.12.2004 DE 102004059200
(71) Anmelder: Fraunhofer-Gesellschaft zur Förderung der angewandten Forschung e.V., 80686 München (DE)
(72) Erfinder: Metzner, Christoph, Dr., 01328 Dresden (DE); Heinss, Jens-Peter, Dr., 01309 Dresden (DE); Kühn, Gerhard, Dr., 01097 Dresden (DE); Tenbusch, Matthias, 01099 Dresden (DE)

(57) **Zusammenfassung**

Die Erfindung betrifft eine Vorrichtung und ein Verfahren zum Kühlen mindestens eines Substrates (11) bei einem Vakuumbearbeitungsprozess, wobei die Wärmeenergie des Substrates (11) durch Wärmeleitung zu einem Kühlkörper (12) abgeführt wird, wobei zwischen Substrat (11) und Kühlkörper (12) eine eine Vielzahl metallischer Borsten (15) umfassende bürstenartige Einrichtung (14) derart angeordnet wird, dass die Borsten (15) der bürstenartigen Einrichtung (14) an einem Ende das Substrat (11) und am anderen Ende den Kühlkörper (12) berühren und dadurch eine Wärmeleitstrecke zwischen Substrat (11) und Kühlkörper (12) ausbilden.

## Beschreibung

Die Erfindung betrifft eine Vorrichtung und ein Verfahren zum Kühlen von Substraten im Vakuum. Vorrichtung und Verfahren können in Vakuumanlagen überall dort zum Einsatz kommen, wo die zu bearbeitenden Substrate einer thermischen Belastung ausgesetzt sind. Beispiele hierfür sind verschiedene Formen der Vakuumbeschichtung, Oberflächenmodifizierungen oder Formen einer gezielten thermischen Behandlung von Oberflächen im Vakuum.

Eine Kühlung zu behandelnder Substrate ist technologisch bedingt häufig erforderlich, wenn ohne Kühlung durch thermische Belastung eine Schädigung des Substrates durch Überhitzung zu erwarten ist oder sich ohne Kühlung eine Substrattemperatur einstellen würde, die einem angestrebten Effekt entgegensteht. Beispiele für letzteres finden sich ebenfalls im Bereich der Vakuumbeschichtung. Häufig soll eine bestimmte Schicht auf einem Substrat abgeschieden werden, die besondere strukturelle Eigenschaften aufweist. Die Schichtstruktur zeigt oft eine starke Abhängigkeit von der Temperatur des Substrates.

Da Kühlen durch Konvektion im Vakuum bei geringen Drücken eine geringe Rolle spielt und effektives Abstrahlen erst bei Temperaturen erfolgt, die bei vielen Beschichtungsverfahren entweder gerade vermieden werden sollen oder durch andere technologische Randbedingungen nicht einstellbar sind, liegt der Schwerpunkt einer Substratkühlung bei Vakuumprozessen auf einer Ableitung der eingetragenen Energie durch Wärmeleitung vom Ort des Energieeintrags, also der Substratoberfläche, in und durch das Substrat hindurch zu einem Kühlkörper. Die Effektivität einer solchen Kühlung hängt im Wesentlichen davon ab, wie effektiv der Wärmeübergang vom Substrat auf den Kühlkörper erfolgen kann.

Es ist bekannt, bandförmige Substrate zu kühlen, indem sie über eine konvexe Kühlfläche, meist Teil der Mantelfläche einer weitgehend zylinderförmigen Kühlwalze, geführt werden. Die Effektivität der Kühlung wird dabei unter anderem über die Temperatur der Kühlwalze beeinflusst. Zu diesem Zweck werden Kühlmittel durch das Innere der Kühlwalze, auch Kühltrommel genannt, geführt (US 4,343,834; US 3,381,660; DE 1 741 856 U). Die Oberfläche der Kühlwalze wird also effektiv gekühlt, indem im Inneren der Kühlwalze eine Flüssigkeitskühlung vorgesehen ist. Dadurch erfolgt ein effektiver Wärmetransport von der Oberfläche der Kühlwalze in deren Inneres.

Die Kühlung der Walze beeinflusst die Temperatur des Substrates. Eine gekühlte Walze führt aber nur dann zu einer effektiven Kühlung des Substrates, wenn Kühlfläche und Substrat in einem innigen Wärmekontakt stehen.

Es ist bekannt, den Wärmekontakt zwischen Substrat und Kühlfläche durch Beilegen einer diesen Kontakt vermittelnden Folie zu verbessern (DE 37 40 483 A1; DE 28 45 131. A1), wobei auch bekannt ist, diese Folie vorzukühlen, wodurch die Wärmekapazität der Folie selbst zur Substratkühlung herangezogen wird. Ansonsten dient die Folie dabei in erster Linie einem Ausgleich von Unebenheiten der sich berührenden Flächen. Der Wärmetransfer durch Folien hindurch erfolgt jedoch insgesamt in für viele Anwendungen ungenügendem Umfang.

Es ist weiterhin bekannt, zum Kühlen bandförmiger Substrate deren Rückseite einer. Kühlgasströmung auszusetzen, bevor das Substrat in Kontakt mit der Kühlfläche kommt (DE 198 53 418 A1; US 5,076,203; US 5,743,966). Die Zufuhr des Kühlgases erfolgt häufig in Form so genannter Gaslanzen. Dadurch soll im Kontaktbereich zwischen Kühlfläche und Substrat ein dünnes Gaspolster bestehen bleiben, das den Wärmekontakt vermitteln kann. Durch Zufuhr des Gases außerhalb des Kontaktbereiches zwischen Substrat und Kühlfläche strömt jedoch ein großer Teil des eingeleiteten Gases in den Prozessraum ab, steht somit nicht dem Gaspolster zwischen Substrat und Kühlfläche zur Verfügung, sondern belastet das Prozessvakuum.

Es ist bekannt, den Wärmekontakt über ein Gaspolster durch elektrische Felder und Plasmen zu intensivieren (GB 2 326 647 A). Die Wirkung derartiger Verfahren ist jedoch gering und lässt sich nur bei ausgewählten Substraten, wie beispielsweise Kunststofffolie, realisieren.

Es ist bekannt, den Rezipienten aus mehreren Bereichen aufzubauen, die vakuumtechnisch teilweise entkoppelt sind (EP 0 311 302 A1). Der Gaseinlass erfolgt dabei außerhalb des Prozessraumes. Eine vollständige Entkopplung lässt sich jedoch auch auf diese Weise nicht oder nur mit großem technischen Aufwand erzielen.

Es ist ebenfalls bekannt, durch Erhöhen des Anpressdruckes zwischen dem Kühlkörper und dem zu kühlenden Substrat den Wärmeübergang zu verbessern. Das erfolgt bei bandförmigen Substraten in der Regel durch Erhöhen des Bandzuges. Dieser Methode sind jedoch ebenfalls physikalische Grenzen gesetzt, da auch bei starker Zunahme des Anpressdruckes die wirksame Kontaktfläche nur geringfügig vergrößert wird, was im Wesentlichen durch mikrogeometrische Gegebenheiten erklärt werden kann.

Es ist bekannt, durch Öffnungen, die durch Ventile geschlossen werden können, Gas unterhalb des zu kühlenden Substrates einzuleiten (US 3,414,048). Die Vielzahl von Ventilen erhöht allerdings die mechanische Anfälligkeit eines solchen Anlagensystems.

Es ist weiterhin bekannt, eine Gaszufuhr durch die Kühlfläche hindurch zu realisieren; indem ein Teil der Kühlfläche als poröser Formkörper ausgebildet wird (US 5,076,203). Nachteilig ist bei diesem Verfahren die große Menge des nach der Substratkühlung in den Rezipienten abströmenden Kühlgases, die das Prozessvakuum belastet.

Schließlich ist bekannt, Kühlgas unter einer Haube durch Löcher in den Ringspält einer Kühltrommel einzulassen (WO 02/070778 A1). Dadurch kann ein bestimmter Gasdruck unter dem Substrat anliegen. Es wird weiterhin erwähnt, den Kontaktbereich zwischen Kühlwalze und Substrat seitlich abzudichten und weitere Einlassoptionen zu nutzen. Auch diese technische Ausführung weist jedoch keinen effektiven Weg, das einmal eingeleitete Kühlgas möglichst effektiv vom Prozessvakuum fernzuhalten, nachdem sich Kühlfläche und zu kühlendes Substrat nicht mehr in Kontakt befinden.

Zusammenfassend kann zum Stand der Technik angemerkt werden, dass der Schwerpunkt der Bemühungen zum Kühlen von Substraten im Vakuum offensichtlich darauf gelegt wird, den Wärmekontakt zwischen Substrat und Kühlkörper durch einen verbleibenden Restspalt mit definierter Gasbefüllung zu vermitteln. Problematisch ist jedoch, dass der hierzu mindestens erforderliche Gasdruck bei bewegten bandförmigen Substraten eine ständige Zufuhr einer erheblichen Gasmenge erfordert, die zumindest teilweise das Prozessvakuum belastet, nachdem sie aus der Kühlzone entwichen ist. Für viele vakuumtechnische Anwendungen, z. B. alle Anwendungen, bei denen mit einem Elektronenstrahl gearbeitet wird, stellt das ein in vielerlei Hinsicht limitierendes Problem dar.

Der Erfindung liegt daher das technische Problem zugrunde eine Vorrichtung und ein Verfahren zu schaffen, die eine gegenüber dem Stand der Technik verbesserte Substratkühlung von Substraten erlauben. Vorrichtung und Verfahren sollen vakuumtauglich sein und die vorgenannten Nachteile des Standes der Technik vermeiden.

Die Lösung des technischen Problems ergibt sich durch die Gegenstände mit den Merkmalen der Patentansprüche 1 und 17. Weitere vorteilhafte Ausgestaltungen der Erfindung ergeben sich aus den abhängigen Ansprüchen.

Beruht der Kühleffekt eines Substrates bei einem Vakuumprozess auf direkter Wärmeleitung zu einem Kühlkörper, wird dann ein hoher Kühleffekt erzielt, wenn Substrat und Kühlkörper einen möglichst großflächigen Kontakt ausbilden. Doch selbst wenn ein Substrat mit glatter Oberfläche an einen Kühlkörper mit glatter Oberfläche gepresst wird, entsteht aufgrund mikrogeometrischer Oberflächengegebenheiten kein vollflächiger Kontakt innerhalb des Kontaktbereiches, sondern erfolgt innerhalb dieses Bereiches der Kontakt zwischen Substrat und Kühlkörper über eine Anzahl von mikrogeömetrischeri Berührungspunkten. Über diese Berührungspunkte vollzieht sich im Wesentlichen auch die Wärmeleitung vom Substrat zum Kühlkörper.

Die Erfindung geht davon aus, dass es zweckmäßig ist, die Anzahl der Berührungspunkte und somit die Gesamtberührungsfläche zwischen Substrat und Kühlkörper zu erhöhen, um einen verbesserten Kühleffekt zu erzielen.

Zur Lösung wird daher eine Vorrichtung und ein Verfahren zum Kühlen mindestens eines Substrates bei einem Vakuumbearbeitungsprozess angegeben, bei denen die Wärmeenergie des Substrates durch Wärmeleitung zu einem Kühlkörper abgeführt wird, indem zwischen Substrat und Kühlkörper eine eine Vielzahl metallischer Borsten umfassende bürstenartige Einrichtung derart angeordnet wird, dass die Borsten der bürstenartigen Einrichtung an einem Ende das Substrat und am anderen Ende den Kühlkörper berühren und dadurch eine Wärmeleitstrecke zwischen Substrat und Kühlkörper ausbilden.

Unter bürstenartiger Einrichtung ist hierbei eine Vielzahl nebeneinander angeordneter und flexibel ausgebildeter, metallischer Borsten zu verstehen. Die Ausrichtung der Borsten zu einem Substrat und einem Kühlkörper kann dabei senkrecht und/oder auch schräg zu deren Oberflächen sein.

Vorrichtung und Verfahren können bei verschiedenartigen Substraten, wie beispielsweise plattenförmigen, bandförmigen Substraten oder auch Substraten mit profilierter Oberflächengeometrie, so genannter 3D-Körper, angewendet werden. Dabei kann die bürstenartige Einrichtung als selbständige Einheit zwischen einem Substrat und einem Kühlkörper angeordnet oder ein Ende der Borsten fest mit dem Kühlkörper verbunden sein.

Die Gestaltung und Anwendung einer bürstenartigen Einrichtung und eines zugehörigen Kühlkörpers ist im Wesentlichen abhängig von der Art und der Form eines zu kühlenden Substrates. Bei plattenförmigen Substraten kann es beispielsweise zweckmäßig sein, die dem Substrat gegenüberliegende Seite des Kühlkörpers eben zu gestalten und die Borsten der bürstenartigen Einrichtung mit gleicher Länge auszubilden. Bei bandförmigen Substraten kann es hingegen vorteilhaft sein, eine konvexe Kühlfläche auszubilden und das Substrat beispielsweise mittels eines Bandlaufwerkes in Richtung konvexer Kühlfläche bzw. gegen eine aus gleichlangen Borsten bestehende bürstenartige Einrichtung zwischen Substrat und Kühlfläche zu drücken, während das bandförmige Substrat an der bürstenartigen Einrichtung vorbeibewegt wird. Die konvexe Kühlfläche kann beispielsweise Teil einer feststehenden Formschulter oder Teil einer Kühlwalze bzw. einer Kühltrommel sein.

Alternativ kann jedoch auch der Kühlkörper mit einer ebenen Oberfläche ausgebildet und die Längen der Borsten der bürstenartigen Einrichtung derart gestaltet werden, dass die dem Substrat zugewandten Enden der Borsten eine konvexe Oberfläche formen, an der das bandförmige Substrat anliegend vorbeibewegt wird.

Bei einer Ausführungsform der Erfindung sind ein Kühlkörper und eine zugehörige bürstenartige Einrichtung als Spanneinrichtung ausgebildet, in welche ein zu kühlendes Substrat eingespannt wird. Dies ist beispielsweise von Vorteil bei Bohrern, deren Spitzen mittels eines Vakuumverfahrens bearbeitet werden. Hierbei wird während des Bearbeitungsprozesses der Schaft eines Bohrers mittels der Spanneinrichtung festgehalten und so die Wärmeenergie des Bohrers über dessen Schaft durch die bürstenartige Einrichtung in den Kühlkörper abgeleitet.

Werden stabförmige Substrate wie beispielsweise Bohrer mit einer derartigen Spanneinrichtung festgehalten, ist es vorteilhaft, die dem Substrat zugewandte Seite des Kühlkörpers konkav auszubilden.

Bei einer weiteren Ausführungsform ist ein Kühlkörper stabförmig ausgebildet und die zugehörige bürstenartige Einrichtung um den stabförmigen Kühlkörper herum angeordnet, so dass deren Borsten mit einem Ende am stabförmigen Kühlkörper befestigt sind und mit dem freien Ende im Wesentlichen senkrecht von der Kühlkörperoberfläche abstehen, ähnlich wie bei einer Flaschenbüste. Eine derartige Vorrichtung ist beispielsweise geeignet rohrförmige Substrate oder Substrate mit zugänglichen Hohlräumen von innen zu kühlen, während deren äußere Oberfläche mittels eines Vakuumverfahrens bearbeitet wird. Dabei wird der Kühlkörper mit bürstenartiger Einrichtung derart in ein Rohr bzw. einen Hohlraum eines Substrates eingebracht, dass die freien Enden der Borsten die innere Oberfläche des Rohres bzw. des Hohlraumes berühren.

Unabhängig von der Gestaltungsform einer bürstenartigen Einrichtung ist bei der Auswahl von Material, Durchmesser, Länge und Bestückungsdichte für deren Borsten darauf zu achten, dass die Borsten eine derartige Flexibilität aufweisen, die es ermöglicht, dass möglichst viele Borsten sowohl ein zu kühlendes Substrat als auch den dafür zur Verfügung stehenden Kühlkörper berühren. Als Borstenmaterial sind gut wärmeleitende und verschleißfeste Metalle bzw. Legierungen zu verwenden. Hierfür sind beispielsweise Borsten aus Kupfer, Bronze, Messing, Stahl, Aluminium oder Edelstahl mit einem Durchmesser von 0,02 mm bis 1 mm und mit einer Länge von 1 mm bis 100 mm geeignet.

Da möglichst viele Wärmeübergangspunkte zwischen einem Substrat und einem Kühlkörper mittels einer bürstenartigen Einrichtung ausgebildet werden sollen, ist es zweckmäßig die Borsten der bürstenartigen Einrichtung mit einer hohen Packungsdichte anzuordnen. Dies hat auch den Vorteil, dass sich die Borsten gegenseitig stützen und somit ein Einknicken der Borsten verhindert wird.

Typische Ausgestaltungen der in erfindungsgemäßen Vorrichtungen verwendeten Kühlkörper stellen reine Festkörper, wie beispielsweise Formschultern, Kühlwalzen oder Kühltrommeln dar. Ein Kühlkörper kann jedoch auch eine Flüssigkeit umfassen, welche den Kühlkörper durchströmt, um diesen zu kühlen.

Bei Verwendung einer drehbaren Kühltrommel oder Kühlwalze kann es vorteilhaft sein, dass Kühltrommel/Kühlwalze und zugehörige bürstenartige Einrichtung eine Relativgeschwindigkeit zu einem zu kühlenden, beispielsweise bandförmigen Substrat aufweisen. D. h., Kühltrommel/Kühlwalze und zugehörige bürstenartige Einrichtung drehen sich schneller bzw. langsamer als die Bandlaufgeschwindigkeit des Substrates oder haben gar eine entgegen gesetzte Drehrichtung. Durch das Einschleifen der Borsten in das bandförmige Substrat kann ein noch besserer Wärmekontakt realisiert werden, wenn die daraus resultierende Oberflächenveränderung der Substratrückseite bezüglich der Qualitätsansprüche akzeptabel ist.

Die vorliegende Erfindung wird nachfolgend anhand bevorzugter Ausführungsbeispiele näher erläutert. Die Fig. zeigen:
- Fig. 1: eine schematische Schnittdarstellung einer Vorrichtung zum Kühlen bandförmiger Substrate,
- Fig. 2: eine schematische Schnittdarstellung einer Vorrichtung zum Kühlen stabförmiger Substrate,
- Fig. 3: eine schematische Schnittdarstellung einer Vorrichtung zum Kühlen eines Substrates mit profilierter Oberfläche,
- Fig. 4: eine schematische Schnittdarstellung einer alternativen Vorrichtung zum Kühlen eines Substrates mit einer profilierten Oberfläche.

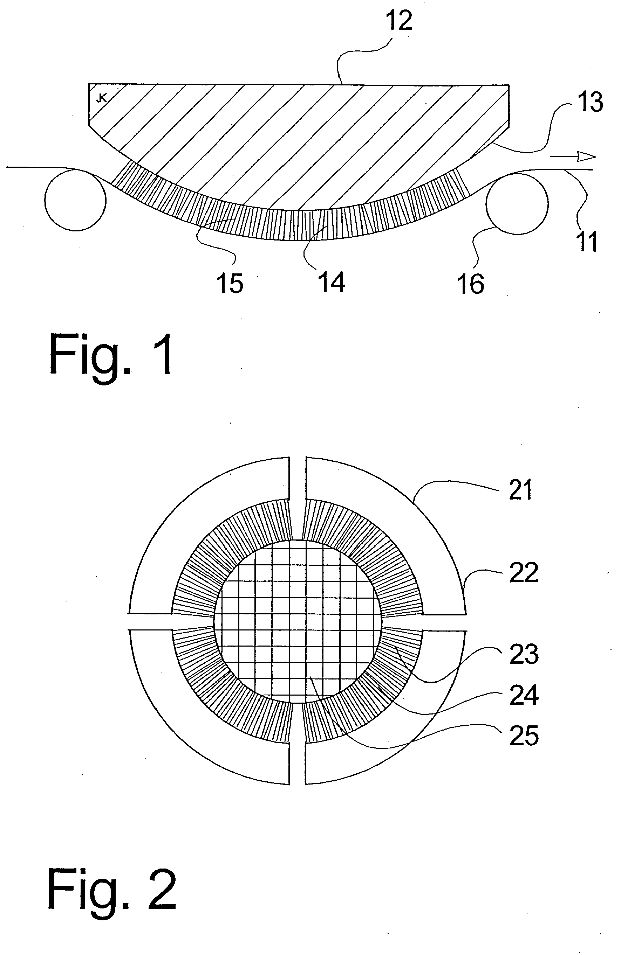

In Fig. 1 schematisch dargestellt ist ein zu kühlendes bandförmiges Substrat 11, welches auf einer Seite mittels eines Vakuumverfahrens innerhalb einer nicht dargestellten Prozesskammer beschichtet werden soll. Die während des Beschichtungsvorgangs in das Substrat 11 eingetragene Wärmeenergie soll dem Substrat 11 durch einen Kühlkörper 12 entzogen werden. Der Kühlkörper 12 ist als feststehende Formschulter ausgebildet und weist eine konvexe Kühlfläche 13 auf, an welcher eine bürstenartige Einrichtung 14, umfassend eine Vielzahl flexibler Borsten 15 befestigt ist. Die Borsten 15 bestehen aus Bronze, haben einen Durchmesser von 0,1 mm, sind im Wesentlichen gleich lang mit einer Länge von 10 mm ausgebildet und weisen eine Packungsdichte von etwa 3000 Stück/cm² auf.

Während des Beschichtungsvorgangs wird das bandförmige Substrat 11 mittels Umlenkrollen 16 an die freien Enden der Borsten 15 gedrückt und somit eine Wärmeleitstrecke vom Substrat 11 über die Borsten 15 zum Kühlkörper 12 ausgebildet. Die flexiblen Borsten 15 stellen sicher, dass im Wesentlichen alle Borsten 15 einen Berührungspunkt mit dem Substrat 11 ausbilden und somit die Wärmeenergie in gewünschtem Maß vom Substrat 11 in den Kühlkörper 12 abfließen kann.

Fig. 2 zeigt schematisch einen rohrförmigen Kühlkörper 21, der im Rohrquerschnitt in vier identische Segmente 22 unterteilt ist, die als Spanneinrichtung ausgebildet sind. Jedes Segment 22 weist an der Rohrinnenseite eine bürstenartige Einrichtung 23 auf, welche aus einer Vielzahl von flexiblen, metallischen Borsten 24 besteht. Die Borsten 24 sind mit einem Ende fest mit den Segmenten 22 verbunden und mit dem freien Ende zum Mittelpunkt des Rohdurchmessers hin ausgerichtet.

Mittels der Segmente 22 kann beispielsweise der Schaft eines Bohrers 25 eingespannt werden, dessen Spitze in einem Vakuumprozesses beschichtet werden soll.

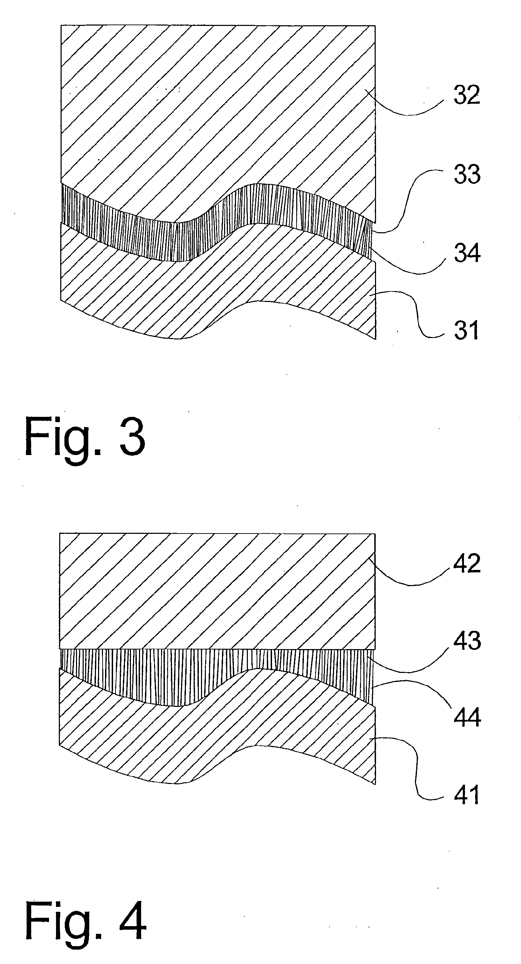

In Fig. 3 und 4 sind Ausführungsbeispiele schematisch veranschaulicht; bei denen Substrate 31 bzw. 41, welche eine profilierte Oberflächenform aufweisen, während eines Vakuumprozesses gekühlt werden sollen. Gemäß Fig. 3 erfolgt dies mittels eines Kühlkörpers 32, dessen Oberflächenform an die Oberflächenform des Substrates 31 angepasst ist. Eine zwischen Substrat 31 und Kühlkörper 32 angeordnete bürstenartige Einrichtung 33 weist eine Vielzahl von Borsten 34 mit gleicher Länge auf.

Alternativ dazu ist die dem Substrat 41 aus Fig. 4 zugewandte Seite eines Kühlkörpers 42 eben geformt. Zwischen Substrat 41 und Kühlkörper 42 ist eine bürstenartige Einrichtung 43 angeordnet, deren Borsten 44 derart gestaltet sind, dass die dem Substrat 41 zugewandten Enden der Borsten 44 die Oberflächenform von Substrat 41 nachbilden. Dadurch wird sichergestellt, dass möglichst alle Borsten 44 sowohl einen Kontakt mit Kühlkörper 42 als auch mit Substrat 41 ausbilden und somit eine optimale Wärmeübertragung von Substrat 41 zu Kühlkörper 42 gewährleisten.

## Patentansprüche

1. Vorrichtung zum Kühlen mindestens eines Substrates (11) bei einem Vakuumbearbeitungsprozess, wobei die Wärmeenergie des Substrates (11) durch Wärmeleitung zu einem Kühlkörper (12) abführbar ist, **dadurch gekennzeichnet, dass** zwischen Substrat (11) und Kühlkörper (12) eine eine Vielzahl metallischer Borsten (15) umfassende bürstenartige Einrichtung (14) derart angeordnet ist; dass die Borsten (15) der bürstenartigen Einrichtung (14) an einem Ende das Substrat (11) und am anderen Ende den Kühlkörper (12) berühren.

2. Vorrichtung nach Anspruch 1, **dadurch gekennzeichnet, dass** das Substrat (11) ein bandförmiges oder plattenförmiges Substrat ist.

3. Vorrichtung nach Anspruch 1, **dadurch gekennzeichnet, dass** das Substrat (31; 41) eine profilierte Oberflächenform aufweist.

4. Vorrichtung nach einem der Ansprüche 1 bis 3, **dadurch gekennzeichnet, dass** die Borsten (34) im Wesentlichen gleich lang sind.

5. Vorrichtung nach einem der Ansprüche 1 bis 3, **dadurch gekennzeichnet, dass** die Längen der Borsten (44) an die Oberflächenform des Substrates (41) angepasst sind.

6. Vorrichtung nach einem der vorhergehenden Ansprüche, **dadurch gekennzeichnet, dass** die Borsten (15) aus Kupfer, Bronze, Messing, Stahl, Aluminium oder Edelstahl bestehen.

7. Vorrichtung nach einem der vorhergehenden Ansprüche, **dadurch gekennzeichnet, dass** die Borsten (15) einen Durchmesser von 0,02 mm bis 1 mm aufweisen.

8. Vorrichtung nach einem der vorhergehenden Ansprüche, **dadurch gekennzeichnet, dass** die Borsten (15) eine Länge von 1 mm bis 100 mm aufweisen.

9. Vorrichtung nach einem der vorhergehenden Ansprüche, **dadurch gekennzeichnet, dass** die Borsten (15) an einem Ende fest mit dem Kühlkörper (12) verbunden sind.

10. Vorrichtung nach einem der Ansprüche 1 bis 9, **dadurch gekennzeichnet, dass** der Kühlkörper als Festkörper ausgebildet ist.

11. Vorrichtung nach einem der Ansprüche 1 bis 9, **dadurch gekennzeichnet, dass** der Kühlkörper eine Flüssigkeit umfasst.

12. Vorrichtung nach einem der vorhergehenden Ansprüche, **dadurch gekennzeichnet, dass** der Kühlkörper (21) als Spannvorrichtung ausgebildet ist.

13. Vorrichtung nach einem der vorhergehenden Ansprüche, **dadurch gekennzeichnet, dass** zumindest ein Teil der Oberfläche des Kühlkörpers (21) konkav ausgebildet ist.

14. Vorrichtung nach einem der Ansprüche 1 bis 12, **dadurch gekennzeichnet, dass** zumindest ein Teil der Oberfläche des Kühlkörpers (12) konvex ausgebildet ist.

15. Vorrichtung nach Anspruch 14, **dadurch gekennzeichnet, dass** der Kühlkörper (12) als Formschulter ausgebildet ist.

16. Vorrichtung nach Anspruch 14, **dadurch gekennzeichnet, dass** der Kühlkörper als Kühlwalze oder Kühltrommel ausgebildet ist.

17. Verfahren zum Kühlen mindestens eines Substrates (11) bei einem Vakuumbearbeitungsprozess, wobei die Wärmeenergie des Substrates (11) durch Wärmeleitung zu einem Kühlkörper (12) abgeführt wird, **dadurch gekennzeichnet, dass** zwischen Substrat (11) und Kühlkörper (12) eine eine Vielzahl metallischer Borsten (15) umfassende bürstenartige Einrichtung (14) derart angeordnet wird, dass die Borsten (15) der bürstenartigen Einrichtung (14) an einem Ende das Substrat (11) und am anderen Ende den Kühlkörper (12) berühren und dadurch eine Wärmeleitstrecke zwischen Substrat (11) und Kühlkörper (12) ausbilden.

18. Verfahren nach Anspruch 17, **dadurch gekennzeichnet, dass** auf das Substrat oder die bürstenartige Einrichtung eine Kraft ausgeübt wird, die den Kontakt zwischen Substrat und bürstenartiger Einrichtung verstärkt.

19. Verfahren nach Anspruch 17 oder 18, **dadurch gekennzeichnet, dass** während des Kühlvorgangs eine Relativbewegung zwischen Substrat und bürstenartiger Einrichtung erzeugt wird.
